Europäisches Patentamt

European Patent Office

Office européen des brevets

(19)

(11) **EP 0 774 188 B1**

(12) **FASCICULE DE BREVET EUROPEEN**

(45) Date de publication et mention
de la délivrance du brevet:
**27.03.2002 Bulletin 2002/13**

(51) Int Cl.[7]: **H04L 25/06**, H03M 5/20

(21) Numéro de dépôt: **95926990.3**

(22) Date de dépôt: **28.07.1995**

(86) Numéro de dépôt international:
**PCT/FR95/01020**

(87) Numéro de publication internationale:
**WO 96/04739 (15.02.1996 Gazette 1996/08)**

(54) **PROCEDE ET DISPOSITIF DE DECODAGE D'UN SIGNAL ELECTRIQUE MULTIVALENT ET ENSEMBLE DE RECEPTION COMPORTANT UN TEL DISPOSITIF DE DECODAGE**

VERFAHREN UND VORICHTUNG ZUM DEKODIEREN EINES MULTIVALENTEN ELEKTRISCHEN SIGNALS UND EMPFANGSGERÄT MIT EINER DEKODIERVORRICHTUNG

METHOD AND DEVICE FOR DECODING A MULTIVALENT ELECTRICAL SIGNAL AND RECEIVER COMPRISING SUCH A DECODING DEVICE

(84) Etats contractants désignés:
**CH DE FR GB IT LI NL**

(30) Priorité: **01.08.1994 FR 9409521**

(43) Date de publication de la demande:
**21.05.1997 Bulletin 1997/21**

(73) Titulaires:
• **Lewiner, Jacques**
  **92210 Saint-Cloud (FR)**
• **Carreel, Eric**
  **F-92190 Meudon (FR)**

(72) Inventeurs:
• **Lewiner, Jacques**
  **92210 Saint-Cloud (FR)**
• **Carreel, Eric**
  **F-92190 Meudon (FR)**

(74) Mandataire: **Burbaud, Eric**
  **Cabinet Plasseraud**
  **84, rue d'Amsterdam**
  **75440 Paris Cédex 09 (FR)**

(56) Documents cités:
  **WO-A-90/16133          GB-A- 2 276 475**
  **US-A- 3 991 379          US-A- 4 163 209**

EP 0 774 188 B1

**Description**

La présente invention est relative aux procédés et aux dispositifs de décodage d'un signal électrique multivalent, et aux ensembles récepteurs comportant de tels dispositifs de décodage.

Plus particulièrement, l'invention concerne un procédé de décodage d'un signal électrique multivalent pouvant prendre un nombre d'états n supérieur à 2, ce signal présentant une grandeur électrique caractéristique qui varie au cours du temps pour prendre successivement des valeurs représentatives chacune d'un des n états du signal électrique, la grandeur électrique caractéristique conservant sensiblement ces valeurs successives pendant des périodes de palier qui ont chacune une durée prédéterminée T constante, ce procédé comportant les étapes suivantes :

> a) mesurer une valeur de la grandeur électrique caractéristique du signal pendant chaque période de palier,
> b) et identifier l'état représenté par chaque valeur mesurée.

Dans un tel procédé, connu par exemple du document US-A-4 163 209, le choix de l'instant où est effectuée chaque mesure est délicat. En effet, une mesure effectuée trop au début ou trop à la fin d'un palier peut être faussée par le fait que la grandeur électrique caractéristique ne reste pas parfaitement constante sur tout le palier. Dans ce cas, l'identification de l'état représenté par la valeur mesurée peut elle-même être faussée.

La présente invention a notamment pour but de pallier ces inconvénients.

A cet effet, selon l'invention, un procédé du genre en question est essentiellement caractérisé en ce que les mesures de la grandeur électrique caractéristique sont effectuées à des instants séparés d'un instant d'origine par un nombre entier de fois la durée T, l'instant d'origine étant déterminé en effectuant des mesures rapprochées de ladite grandeur électrique caractéristique pendant une période prédéterminée dite de synchronisation, à des instants séparés les uns des autres par une durée T/m, ou m est un nombre entier au moins égal à 3, ces mesures rapprochées étant utilisées pour repérer les périodes de palier de la grandeur électrique caractéristique, l'instant d'origine étant fixé sensiblement à la moitié d'une de ces périodes de palier.

De plus, au contraire du décodage d'un signal bivalent où il est facile de discriminer un niveau haut et un niveau bas du signal, l'identification de l'état représenté par chaque valeur mesurée peut être perturbée relativement facilement par des variations de ladite grandeur électrique caractéristique qui peuvent être dues notamment aux variations de température des circuits électroniques qui traitent le signal et au vieillissement de ces circuits.

En outre, lorsque le procédé de décodage s'applique à un signal électrique qui résulte de la démodulation d'un signal radioélectrique précédemment capté, par exemple lorsque ce signal radioélectrique est modulé en fréquence, en amplitude ou en phase, les variations perturbatrices de la grandeur électrique caractéristique peuvent également être dues à la plus ou moins bonne qualité de réception du signal radioélectrique.

Afin de permettre une adaptation aux variations perturbatrices de la grandeur électrique caractéristique du signal électrique multivalent, selon une forme de réalisation avantageuse de l'invention, l'étape b) susmentionnée est réalisée en comparant la valeur mesurée à $n-1$ seuils $S_1$, $S_2$... $S_{n-1}$ qui délimitent n plages de valeurs correspondant chacune à un état du signal électrique, ces seuils étant fixés préalablement au moins en fonction d'une valeur minimale $U_1$ et une valeur maximale $U_n$ de la grandeur électrique caractéristique (U), mesurées pendant une période prédéterminée dite d'adaptation.

Dans d'autres modes de réalisation préférés du procédé de l'invention, on a recours en outre à l'une et/ou à l'autre des dispositions suivantes :

- on détermine les différents seuils $S_1$, $S_2$... $S_{n-1}$ non seulement en fonction des valeurs mesurées $U_1$, $U_2$... $U_n$, mais également en fonction de valeurs théoriques $U_10$, $U_20$... $U_n0$ que devrait prendre la grandeur électrique caractéristique (U) pour les différents états du signal ;

- les différents seuils valent :

$$(II) \qquad S_k = U_1 + (U_k0 - U_10) \cdot \frac{U_n - U_1}{U_n0 - U_10}$$

$$+ \frac{1}{2}(U_{k+1}0 - U_k0) \cdot \frac{U_n - U_1}{U_n0 - U_10}$$

où k est un nombre entier compris entre 1 et n-1, $U_10$ étant la plus petite des valeurs théoriques susmentionnées, $U_n0$ étant la plus grande des valeurs théoriques susmentionnées, et $U_k0$ et $U_{k+1}0$ étant respectivement les k ièmes et (k+1) ièmes de ces valeurs théoriques par ordre croissant ;

- pendant la période d'adaptation, on mesure des valeurs $U_1$, $U_2$... $U_n$ de la grandeur électrique caractéristique (U) qui correspondent respectivement aux n états du signal, les différents seuils valant alors

$$S_k = \frac{U_k + U_{k+1}}{2}$$

où k est un nombre entier compris entre 1 et n-1, $U_k$ et $U_{k+1}$ étant respectivement les k ièmes et (k+1) ièmes desdites valeurs mesurées, par ordre croissant ;

- les différents seuils valent :

$$(I) \qquad S_k = U_1 + (k - 0,5) \cdot \frac{U_n - U_1}{n - 1}$$

où k est un nombre entier compris entre 1 et n - 1 ;

- les n - 1 seuils $S_1$, $S_2$... $S_{n-1}$ sont mis à jour régulièrement pendant le décodage du signal, en déterminant au moins les valeurs minimales $U_1$ et maximale $U_n$ de la grandeur électrique caractéristique pendant des périodes d'adaptation successives ;
- lors du calcul des seuils $S_1$, $S_2$ ... $S_{n-1}$, on compare les valeurs minimale $U_1$ et maximale $U_n$, déterminées pendant la période d'adaptation, respectivement à une première et à une deuxième plages de valeurs prédéterminées, la valeur minimale étant rejetée si elle n'est pas située à l'intérieur de la première plage de valeurs et la valeur maximale étant rejetée si elle n'est pas située à l'intérieur de la deuxième plage de valeurs ;
- les n - 1 seuils comportent un seuil minimum $S_1$ et un seuil maximum $S_{n-1}$, et pendant l'étape b), chaque valeur mesurée de la grandeur électrique caractéristique du signal est comparée d'une part à une valeur $S_1 - \Delta$ et d'autre part à une valeur $S_{n-1} + \Delta$, $\Delta$ étant une valeur prédéterminée, la valeur mesurée n'étant pas prise en compte si elle est inférieure à $S_1 - \Delta$ ou supérieure à $S_{n-1} + \Delta$ ;
- la valeur $\Delta$ représente une fraction constante de la différence entre le seuil maximum $S_{n-1}$ et le seuil minimum $S_1$ ;
- m est un entier au moins égal à 7 ;
- le signal électrique résulte de la démodulation d'un signal radioélectrique qui peut être modulé en fréquence, en amplitude ou en phase.

L'invention a également pour objet un dispositif de décodage d'un signal électrique multivalent pouvant prendre un nombre d'états n supérieur à 2, ce signal présentant une grandeur électrique caractéristique qui varie au cours du temps pour prendre successivement des valeurs représentatives chacune d'un des n états du signal électrique, la grandeur électrique caractéristique conservant sensiblement ces valeurs successives pendant des périodes de palier qui ont chacune une durée prédéterminée T constante, ce dispositif comportant des moyens de décodage pour :

a) mesurer une valeur de la grandeur électrique caractéristique du signal pendant chaque période de palier,
b) et identifier l'état représenté par chaque valeur mesurée,

caractérisé en ce que les moyens de décodage effectuent les mesures de la grandeur électrique à des instants séparés d'un instant d'origine par un nombre entier de fois la durée T, lesdits moyens de décodage étant prévus pour déterminer l'instant d'origine en effectuant des mesures rapprochées de ladite grandeur électrique caractéristique pendant une période prédéterminée dite de synchronisation, à des instants séparés les uns des autres par une durée T/m où m est un nombre entier au moins égal à 4, les moyens de décodage étant également conçus pour utiliser ces mesures rapprochées afin de repérer les périodes de palier de la grandeur électrique caractéristique et les moyens de décodage étant enfin conçus pour fixer l'instant d'origine sensiblement à la moitié d'une de ces périodes de palier.

Dans des modes de réalisation préférés du dispositif de décodage selon l'invention, on a recours en outre à l'une et/ou à l'autre des dispositions suivantes :

- les moyens de décodage sont prévus pour identifier l'état représenté par chaque valeur mesurée en comparant cette valeur mesurée à n - 1 seuils $S_1$, $S_2$... $S_{n-1}$ qui délimitent n plages de valeurs correspondant chacune à un état du signal électrique, les moyens de décodage étant également prévus pour fixer préalablement ces seuils au moins en fonction d'une valeur minimale $U_1$ et d'une valeur maximale $U_n$ de la grandeur électrique caractéristique mesurées pendant une période prédéterminée dite d'adaptation ;
- les moyens de décodage sont prévus pour mesurer, pendant la période d'adaptation, des valeurs $U_1$, $U_2$... $U_n$ de la grandeur électrique caractéristique qui correspondent respectivement aux n états du signal et pour calculer les différents seuils par la formule suivante :

$$S_k = \frac{U_k + U_{k+1}}{2}$$

où k est un nombre entier compris entre 1 et n-1, et le dispositif comportant en outre une mémoire rémanente dans laquelle sont stockées lesdites différentes valeurs $U_1$, $U_2$... $U_n$ mesurées pendant la période d'adaptation.

L'invention a également pour objet un ensemble récepteur comportant une antenne pour recevoir un signal radioélectrique modulé en fréquence, des moyens pour générer un signal électrique démodulé à partir du signal radioélectrique modulé en fréquence capté par l'antenne, et un dispositif de décodage tel que défini ci-dessus pour décoder le signal électrique démodulé.

D'autres caractéristiques et avantages de l'invention apparaîtront au cours de la description détaillée suivante d'une de ses formes de réalisation, donnée à titre d'exemple non limitatif, en regard des dessins joints.

Sur les dessins :

- la figure 1 est une vue d'un ensemble récepteur de radiomessagerie pouvant recevoir et décoder des signaux multivalents conformément à la présente invention,
- la figure 2 est un schéma fonctionnel partiel de l'ensemble récepteur de la figure 1, et
- la figure 3 représente un exemple d'évolution du signal électrique résultant de la démodulation du signal radioélectrique capté par l'ensemble récepteur de la figure 1.

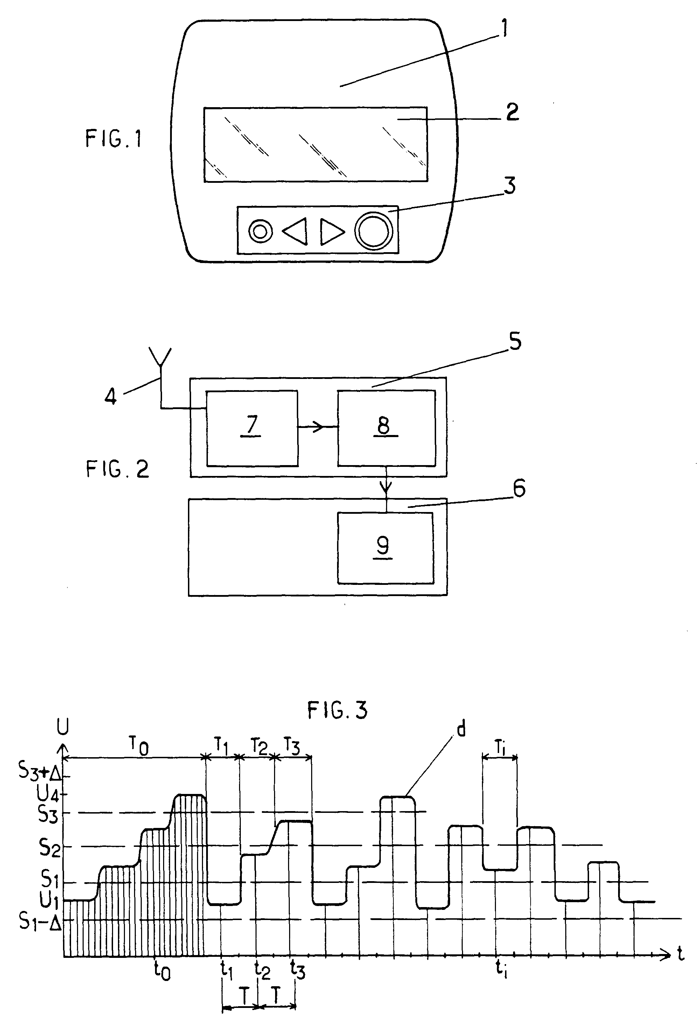

La présente invention s'applique particulièrement, mais de façon non limitative, à un boîtier portatif 1 de radiomessagerie, représenté sur la figure 1.

Ce boîtier 1 peut recevoir des messages par voie hertzienne, et il présente un écran 2 pour afficher ces messages et un clavier 3 permettant notamment de faire défiler ces messages, de les effacer, etc.

Comme représenté schématiquement sur la figure 2, le boîtier 1 contient notamment un récepteur 5 et une unité centrale 6 qui peut être constituée par un microprocesseur doté d'une horloge.

Le récepteur 5 comporte un amplificateur 7 et un démodulateur 8, l'amplificateur 7 présentant une entrée reliée à une antenne 4 et une sortie reliée à une entrée du démodulateur 8, ce démodulateur 8 présentant lui-même une sortie reliée à une entrée analogique de l'unité centrale 6.

Le boîtier récepteur 1 est spécialement conçu pour recevoir un signal radioélectrique modulé multivalent pouvant prendre un nombre d'états n supérieur à 2 et dans le cas présent égal à 4.

De plus, l'invention s'applique plus spécifiquement, mais de façon non limitative au cas où le signal radioélectrique est modulé en fréquence.

L'invention s'applique encore plus spécifiquement, mais également de façon non limitative, au cas où le signal radioélectrique est émis selon la norme européenne ERMES (Directives CEE 85/374 et 92/59).

Le signal radioélectrique est reçu par l'antenne 4, amplifié par l'amplificateur 7, et démodulé par le démodulateur 8, qui génère un signal démodulé d.

Comme représenté sur la figure 3, le signal démodulé d en sortie du démodulateur 8 présente une tension U qui varie au cours du temps en prenant successivement des valeurs représentatives chacune d'un des quatre états de signal radioélectrique, la tension U conservant sensiblement ces valeurs successives pendant des périodes dites de palier $T_1$, $T_2$, $T_3$... $T_i$ ayant chacune une durée prédéterminée T constante.

Le signal démodulé d généré à la sortie du démodulateur 8 est traité au sein de l'unité centrale 6 par un décodeur 9 constitué généralement par un programme chargé dans l'unité centrale 6.

A chaque mise en service du boîtier 1, le décodeur 9 commence par se synchroniser sur le signal démodulé d en effectuant un grand nombre de mesure de la tension U à des instants très proches les uns des autres, et ce pendant une période dite de synchronisation $T_0$.

Au cours de cette période de synchronisation, les mesures de la tension U sont effectuées à des instants qui sont séparés les un des autres par une durée T/m, où m est un entier au moins égal à 3, ou de préférence au moins égal à 7.

Grâce à ces mesures rapprochées les unes des autres, le décodeur 9 détermine les différentes périodes de palier contenues à l'intérieur de la période de synchronisation $T_0$, et il fixe un instant d'origine $t_0$ sensiblement à la moitié d'une de ces périodes de palier.

Après la période de synchronisation $T_0$, le décodeur 9 effectue une seule mesure de la tension U pour chaque période de palier $T_1$, $T_2$, $T_3$... $T_i$, à des instants $t_1$, $t_2$ $t_3$... $t_i$ qui sont séparés chacun de l'instant d'origine $t_0$ par un nombre entier de fois la durée prédéterminée T.

Eventuellement, le décodeur 9 peut à nouveau se synchroniser sur le signal démodulé d au bout d'un certain temps de fonctionnement, selon le processus décrit ci-dessus.

Par ailleurs, pour identifier l'état du signal qui correspond à chaque valeur mesurée de la tension U aux instants $T_1$, $T_2$, $T_3$... $T_i$, le décodeur 9 compare chaque valeur mesurée de la tension U à trois seuils $S_1$, $S_2$, $S_3$, qui délimitent quatre plages de valeurs correspondant chacune à un état du signal électrique :

| ETATS | PLAGES DE VALEURS |
|-------|-------------------|
| 00 | $U < S_1$ |
| 01 | $S_1 \leq U < S_2$ |
| 11 | $S_2 \leq U < S_3$ |
| 10 | $U \geq S_3$ |

De préférence, les trois seuils $S_1$, $S_2$, $S_3$ sont fixés préalablement en déterminant une valeur minimale $U_1$ et une valeur maximale $U_4$ de la tension U pendant une période dite d'adaptation, les différents seuils valant alors :

$$(I) \qquad S_k = U_1 + (k - 0,5) \cdot \frac{U_4 - U_1}{3}$$

où k est un nombre entier compris entre 1 et 3.

Lorsque les écarts entre les différentes valeurs $U_1$, $U_2$, $U_3$, $U_4$ ne sont pas égaux, en particulier lorsque le démodulateur 8 n'est pas linéaire, on peut calculer les différents seuils $S_1$, $S_2$, $S_3$ non plus avec la formule (I) ci-dessus, mais en fonction de valeurs théoriques $U_1 0$, $U_2 0$, $U_3 0$, $U_4 0$ que devrait prendre la tension U pour les différents états du signal, ces valeurs théoriques étant stockées dans une mémoire rémanente, par exemple une mémoire de type EEPROM du décodeur 9.

La valeur des différents seuils est alors

$$\text{(II)} \qquad S_k = U_1 + (U_k0 - U_10) \cdot \frac{U_4 - U_1}{U_40 - U_10}$$

$$+ \frac{1}{2}(U_{k+1}0 - U_k0) \cdot \frac{U_4 - U_1}{U_40 - U_10}$$

où k est un nombre entier compris entre 1 et 3.

Il est également possible de mesurer les valeurs $U_1$, $U_2$, $U_3$, $U_4$ de la tension U pendant la période d'adaptation et de calculer ensuite les différents seuils par la formule :

$$S_k = \frac{U_k + U_{k+1}}{2}$$

où k est un nombre entier compris entre 1 et 3.

Dans ce cas, de préférence, les valeurs mesurées $U_1$, $U_2$, $U_3$, $U_4$ pendant la période d'adaptation sont ensuite stockées dans une mémoire rémanente du décodeur 9.

Lors de la mise en service du boîtier 1, la période d'adaptation peut être confondue avec la période de synchronisation $T_0$, ou bien cette période d'adaptation peut être postérieure à la période de synchronisation $T_0$. De préférence, les seuils $S_1$, $S_2$, $S_3$, sont mis à jour régulièrement pendant le décodage du signal d, en déterminant les valeurs minimale et maximale $U_1$ et $U_4$ de la tension pendant des périodes d'adaptation successives, ces périodes d'adaptation pouvant revenir à intervalles de temps réguliers, ou bien l'adaptation étant permanente, et la période d'adaptation correspondant alors par exemple aux p dernières mesures de la tension U, où p est un nombre entier.

Par ailleurs, lors du calcul des seuils $S_1$, $S_2$, $S_3$, il est possible de comparer les valeurs $U_1$ et $U_4$ respectivement à une première et à une deuxième plages de valeurs prédéterminées, la valeur $U_1$ n'étant pas prise en compte si elle n'est pas située à l'intérieur de la première plage de valeur, et la valeur $U_4$ n'étant pas prise en compte si elle n'est pas située à l'intérieur de la deuxième plage de valeur.

Eventuellement pendant le décodage, les valeurs mesurées de la tension U qui sont inférieures à une valeur $S_1 - \Delta$ ou supérieur à une valeur $S_3 + \Delta$, $\Delta$ étant une tension prédéterminée, sont éliminées comme étant des parasites.

La tension $\Delta$ peut éventuellement représenter une fraction constante de la différence entre le seuil maximum $S_3$ et le seuil minimum $S_1$, par exemple $\Delta = (S_3 - S_1)/2$ comme représenté sur la figure 3.

Comme il va de soi, et comme il résulte d'ailleurs déjà de ce qui précède, l'invention ne se limite nullement à ceux de ses modes d'application et de réalisation qui ont été plus spécialement envisagés ; elle en embrasse, au contraire, toutes les variantes.

## Revendications

1. Procédé de décodage d'un signal électrique (d) multivalent pouvant prendre un nombre d'états n supérieur à 2, ce signal présentant une grandeur électrique caractéristique (U) qui varie au cours du temps pour prendre successivement des valeurs représentatives chacune d'un des n états du signal électrique (d), la grandeur électrique caractéristique conservant sensiblement ces valeurs successives pendant des périodes de palier ($T_1$, $T_2$, $T_3$... $T_i$) qui ont chacune une durée prédéterminée T constante, ce procédé comportant les étapes suivantes :

   a) mesurer une valeur de la grandeur électrique caractéristique du signal pendant chaque période de palier ($T_1$, $T_2$, $T_3$ ... $T_i$),
   b) et identifier l'état représenté par chaque valeur mesurée,

   **caractérisé en ce que** les mesures de la grandeur électrique caractéristique (U) sont effectuées à des instants ($t_1$, $t_2$... $t_i$) séparés d'un instant d'origine ($t_0$) par un nombre entier de fois la durée T, l'instant d'origine ($t_0$) étant déterminé en effectuant des mesures rapprochées de ladite grandeur électrique caractéristique pendant une période prédéterminée dite de synchronisation, à des instants séparés les uns des autres par une durée T/m, ou m est un nombre entier au moins égal à 3, ces mesures rapprochées étant utilisées pour repérer les périodes de palier de la grandeur électrique caractéristique (U), l'instant d'origine ($t_0$) étant fixé sensiblement à la moitié d'une de ces périodes de palier.

2. Procédé selon la revendication 1, dans lequel l'étape b) susmentionnée est réalisée en comparant la valeur mesurée à n-1 seuils $S_1$, $S_2$... $S_{n-1}$ qui délimitent n plages de valeurs correspondant chacune à un état du signal électrique, ces seuils étant fixés préalablement au moins en fonction d'une valeur minimale $U_1$ et d'une valeur maximale $U_n$ de la grandeur électrique caractéristique (U) mesurées pendant une période prédéterminée dite d'adaptation.

3. Procédé selon la revendication 2, dans lequel on détermine les différents seuils $S_1$, $S_2$... $S_{n-1}$ non seulement en fonction des valeurs mesurées $U_1$, $U_2$... $U_n$, mais également en fonction de valeurs théoriques $U_10$, $U_20$... $U_n0$ que devrait prendre la grandeur électrique caractéristique (U) pour les différents états du signal.

4. Procédé selon la revendication 3, dans lequel les différents seuils valent :

$$(II) \qquad S_k = U_1 + (U_k0 - U_10) \cdot \frac{U_n - U_1}{U_n0 - U_10}$$

$$+ \frac{1}{2} (U_{k+1}0 - U_k0) \cdot \frac{U_n - U_1}{U_n0 - U_10}$$

où k est un nombre entier compris entre 1 et n-1, $U_10$ étant la plus petite des valeurs théoriques susmentionnées, $U_n0$ étant la plus grande des valeurs théoriques susmentionnées, et $U_k0$ et $U_{k+1}0$ étant respectivement les k ièmes et (k+1) ièmes de ces valeurs théoriques par ordre croissant.

5. Procédé selon la revendication 2, dans lequel pendant la période d'adaptation, on mesure des valeurs $U_1$, $U_2$... $U_n$ de la grandeur électrique caractéristique (U) qui correspondent respectivement aux n états du signal, les différents seuils valant alors

$$S_k = \frac{U_k + U_{k+1}}{2}$$

où k est un nombre entier compris entre 1 et n-1, $U_k$ et $U_{k+1}$ étant respectivement les k ièmes et (k+1) ièmes desdites valeurs mesurées, par ordre croissant.

6. Procédé selon la revendication 2, dans lequel les différents seuils valent :

$$(I) \qquad S_k = U_1 + (k - 0{,}5) \cdot \frac{U_n - U_1}{n - 1}$$

où k est un nombre entier compris entre 1 et n - 1.

7. Procédé selon l'une quelconque des revendications 2 à 6 dans lequel les n-1 seuils $S_1$, $S_2$... $S_{n-1}$ sont mis à jour régulièrement pendant le décodage du signal (d), en déterminant au moins les valeurs minimale $U_1$ et maximale $U_n$ de la grandeur électrique caractéristique pendant des périodes d'adaptation successives.

8. Procédé selon l'une quelconque des revendications 2 à 7, dans lequel, lors du calcul des seuils $S_1$, $S_2$... $S_{n-1}$, on compare les valeurs minimale $U_1$ et maximale $U_n$ déterminées pendant la période d'adaptation, respectivement à une première et à une deuxième plages de valeurs prédéterminées, la valeur minimale étant rejetée si elle n'est pas située à l'intérieur de la première plage de valeurs et la valeur maximale étant rejetée si elle n'est pas située à l'intérieur de la deuxième plage de valeurs.

9. Procédé selon l'une quelconque des revendications 2 à 8, dans lequel les n - 1 seuils comportent un seuil minimum $S_1$ et un seuil maximum $S_{n-1}$, et dans lequel, pendant l'étape b), chaque valeur mesurée de la grandeur électrique caractéristique du signal est comparée d'une part à une valeur $S_1 - \Delta$ et d'autre part à une valeur $S_{n-1} + \Delta$, $\Delta$ étant une valeur prédéterminée, la valeur mesurée n'étant pas prise en compte si elle est inférieure à $S_1 - \Delta$ ou supérieure à $S_{n-1} + \Delta$.

10. Procédé selon la revendication 9, dans lequel la valeur $\Delta$ représente une fraction constante de la différence entre le seuil maximum $S_{n-1}$ et le seuil minimum $S_1$.

11. Procédé selon l'une quelconque des revendications précédentes, dans lequel m est un entier au moins égal à 7.

12. Procédé selon l'une quelconque des revendications précédentes, dans lequel le signal électrique (d) résulte de la démodulation d'un signal radioélectrique modulé.

13. Dispositif de décodage d'un signal électrique (d) multivalent pouvant prendre un nombre d'états n supérieur à 2, ce signal présentant une grandeur électrique caractéristique (U) qui varie au cours du temps pour prendre successivement des valeurs représentatives chacune d'un des n états du signal électrique (d), la grandeur électrique caractéristique conservant sensiblement ces valeurs successives pendant des périodes de palier ($T_1$, $T_2$, $T_3$... $T_i$) qui ont chacune une durée prédéterminée T constante, ce dispositif comportant des moyens de décodage (9) pour :

    a) mesurer une valeur de la grandeur électrique caractéristique du signal pendant chaque période de palier ($T_1$, $T_2$, $T_3$... $T_i$),
    b) et identifier l'état représenté par chaque valeur mesurée,

**caractérisé en ce que** les moyens de décodage (9) effectuent les mesures de la grandeur électrique à des instants ($t_1$, $t_2$... $t_i$) séparés d'un instant d'origine ($t_0$) par un nombre entier de fois la durée T, lesdits moyens de décodage (9) étant prévus pour déterminer l'instant d'origine ($t_0$) en effectuant des mesures rapprochées de ladite grandeur électrique caractéristique pendant une période prédéterminée dite de synchronisation, à des instants séparés les uns des autres par une durée T/m où m est un nombre entier au moins égal à 3, les moyens de décodage étant également conçus pour utiliser ces mesures rapprochées afin de repérer les périodes de palier de la grandeur électrique caractéristique (U) et les moyens de décodage (9) étant enfin conçus pour fixer l'instant d'origine ($t_0$) sensiblement à la moitié d'une de ces périodes de palier.

14. Dispositif selon la revendication 13, dans lequel les moyens de décodage (9) sont prévus pour identifier l'état représenté par chaque valeur mesurée en comparant cette valeur mesurée à n - 1 seuils $S_1$, $S_2$... $S_{n-1}$ qui délimitent n plages de valeurs correspondant chacune à un état du signal électrique, les moyens de décodage étant également prévus pour fixer préalablement ces seuils au moins en fonction d'une valeur minimale $U_1$ et d'une valeur maximale $U_n$ de la grandeur électrique caractéristique (U) mesurées pendant une période prédéterminée dite d'adaptation.

15. Dispositif selon la revendication 14, dans lequel les moyens de décodage sont prévus pour mesurer, pendant la période d'adaptation, des valeurs $U_1$, $U_2$... $U_n$ de la grandeur électrique caractéristique qui correspondent respectivement aux n états du signal et pour calculer les différents seuils par la formule suivante :

$$S_k = \frac{U_k + U_{k+1}}{2}$$

k étant un nombre entier compris entre 1 et n-1, et le dispositif comportant en outre une mémoire rémanente dans laquelle sont stockées lesdites différentes valeurs $U_1$, $U_2$... $U_n$ mesurées pendant la période d'adaptation.

16. Ensemble récepteur (1) comportant une antenne (4) pour recevoir un signal radioélectrique modulé en fréquence, des moyens (7, 8) pour générer un signal électrique démodulé (d) à partir du signal radioélectrique modulé en fréquence capté par l'antenne (4), et un dispositif selon l'une quelconque des revendications 13 à 15, pour décoder le signal électrique démodulé (d).

**Patentansprüche**

1. Verfahren zum Decodieren eines multivalenten elektrischen Signals (d), das eine Anzahl von Zuständen n größer als 2 annehmen kann, wobei dieses Signal eine charakteristische elektrische Größe (U) aufweist, die sich im Verlaufe der Zeit ändert, um aufeinanderfolgend Werte anzunehmen, die jeweils repräsentativ für einen der n Zustände des elektrischen Signals (d) sind, wobei die charakteristische elektrische Größe im wesentlichen diese aufeinanderfolgenden Werte während Stufenperioden ($T_1$, $T_2$, $T_3$... $T_i$) aufrechterhält, die jeweils eine konstante, vorher festgelegte Dauer T haben, wobei dieses Verfahren folgende Schritte umfaßt:

a) Messen eines Wertes der charakteristischen elektrischen Größe des Signals während jeder Stufenperiode ($T_1$, $T_2$, $T_3$... $T_i$),
b) und Identifizieren des durch jeden gemessenen Wert dargestellten Zustandes,

**dadurch gekennzeichnet, daß** die Messungen der charakteristischen elektrischen Größe (U) zu Zeitpunkten (t1, t2... ti) ausgeführt werden, die von einem Ursprungszeitpunkt ($t_0$) durch eine ganzzahliges Vielfaches der Dauer T getrennt sind, wobei der Ursprungszeitpunkt ($t_0$) bestimmt wird, indem dicht aufeinanderfolgende Messungen der charakteristischen elektrischen Größe während einer vorher festgelegten sogenannten Synchronisierungsperiode in zueinander durch eine Dauer T/m getrennten Zeitpunkten ausgeführt werden, wobei m eine ganze Zahl von wenigstens 3 ist, wobei diese dicht aufeinanderfolgenden Messungen benutzt werden, um die Stufenperioden der charakteristischen elektrischen Größe (U) festzulegen, wobei der Ursprungszeitpunkt ($t_0$) im wesentlichen bei der Hälfte einer dieser Stufenperioden festgesetzt wird.

2. Verfahren nach Anspruch 1, bei dem der vorher erwähnte Schritt b) ausgeführt wird, indem der gemessene Wert mit n-1 Schwellen $S_1$, $S_2$... $S_{n-1}$ verglichen wird, die n Bereiche von Werten begrenzen, die jeweils einem Zustand des elektrischen Signals entsprechen, wobei diese Schwellen vorher abhängig wenigstens von einem Minimalwert $U_1$ und von einem Maximalwert $U_n$ der während einer vorher festgelegten sogenannten Anpaßperiode gemessenen charakteristischen elektrischen Größe (U) festgesetzt werden.

3. Verfahren nach Anspruch 2, bei dem die verschiedenen Schwellen $S_1$, $S_2$... $S_{n-1}$ nicht nur abhängig von den gemessenen Werten $U_1$, $U_2$... $U_n$, sondern auch abhängig von den theoretischen Werten $U_1O$, $U_2O$... $U_nO$ ermittelt werden, welche die charakteristische elektrische Größe (U) für die verschiedenen Zustände des Signals annehmen sollte.

4. Verfahren nach Anspruch 3, bei dem für die verschiedenen Schwellen gilt:

$$(II) \qquad S_k = U_1 + (U_kO - U_1O) \cdot \frac{U_n - U_1}{U_nO - U_1O}$$

$$+ \frac{1}{2}(U_{k+1}O - U_kO) \cdot \frac{U_n - U_1}{U_nO - U_1O} \,,$$

worin k eine ganze Zahl zwischen 1 und n-1 ist, wobei $U_1O$ der kleinste der vorher erwähnten theore-

tischen Werte ist, $U_nO$ der größte der vorher erwähnten theoretischen Werte ist und $U_kO$ bzw. $U_{k+1}O$ der k-te bzw. (k+1)-te Wert dieser theoretischen Werte bei ansteigender Ordnung sind.

5. Verfahren nach Anspruch 2, bei dem während der Anpaßperiode Werte $U_1$, $U_2$... $U_n$ der charakteristischen elektrischen Größe (U) gemessen werden, die den n betreffenden Zuständen des Signals entsprechen, wobei für die verschiedenen Schwellen dann

$$S_k = \frac{U_k + U_{k+1}}{2}$$

gilt, worin k eine ganze Zahl zwischen 1 und n-1 ist , wobei $U_k$ bzw. $U_{k+1}$ der k-te bzw. (k+1)-te der gemessenen Werte bei ansteigender Ordnung ist.

6. Verfahren nach Anspruch 2, bei dem für die verschiedenen Schwellen gilt:

$$(I) \qquad S_k = U_1 + (k - 0{,}5) \cdot \frac{U_n - U_1}{n - 1} \ ,$$

worin k eine ganze Zahl zwischen 1 und n-1 ist.

7. Verfahren nach einem der Ansprüche 2 bis 6, bei dem die n-1 Schwellen $S_1$, $S_2$... $S_{n-1}$ regelmäßig während der Decodierung des Signals (d) auf den neuesten Stand gebracht werden, wobei wenigstens der Minimalwert $U_1$ und der Maximalwert $U_n$ der charakteristischen elektrischen Größe während der aufeinanderfolgenden Anpaßperioden ermittelt werden.

8. Verfahren nach einem der Ansprüche 2 bis 7, bei dem bei der Berechnung der Schwellen $S_1$, $S_2$... $S_{n-1}$ der ermittelte Minimalwert $U_1$ und Maximalwert $U_n$, die während der Anpaßperiode ermittelt wurden, mit einem ersten Bereich bzw. einem zweiten Bereich von vorher festgelegten Werten verglichen werden, wobei der Minimalwert zurückgewiesen wird, wenn er nicht innerhalb des ersten Bereiches der Werte liegt, und der Maximalwert zurückgewiesen wird, wenn er nicht innerhalb des zweiten Bereiches der Werte liegt.

9. Verfahren nach einem der Ansprüche 2 bis 8, bei dem die n-1 Schwellen eine Minimalschwelle $S_1$ und eine Maximalschwelle $S_{n-1}$ enthalten und bei dem während des Schrittes b) jeder gemessene Wert der charakteristischen elektrischen Größe des Signals einerseits mit einem Wert $S_1 - \Delta$ und andererseits mit einem Wert $S_{n-1} + \Delta$ verglichen wird, wobei $\Delta$ ein vorher festgelegter Wert ist, wobei der gemessene Wert nicht berücksichtigt wird, wenn er kleiner als $S_1 - \Delta$ oder größer als $S_{n-1} + \Delta$ ist.

10. Verfahren nach Anspruch 9, bei dem der Wert $\Delta$ einen konstanten Bruchteil der Differenz zwischen der Maximalschwelle $S_{n-1}$ und der Minimalschwelle $S_1$ darstellt.

11. Verfahren nach einem der vorhergehenden Ansprüche, bei dem m ganzzahlig und wenigstens gleich 7 ist.

12. Verfahren nach einem der vorhergehenden Ansprüche, bei dem sich das elektrische Signal (d) aus der Demodulation eines modulierten Funksignals ergibt.

13. Vorrichtung zum Decodieren eines multivalenten elektrischen Signals (d), das eine Anzahl von Zuständen n größer als 2 annehmen kann, wobei dieses Signal eine charakteristische elektrische Größe (U) aufweist, die sich im Verlaufe der Zeit ändert, um aufeinanderfolgend Werte anzunehmen, die jeweils repräsentativ für einen der n Zustände des elektrischen Signals (d) sind, wobei die charakteristische elektrische Größe im wesentlichen diese aufeinanderfolgenden Werte während Stufenperioden ($T_1$, $T_2$, $T_3$... $T_i$) aufrechterhält, die jeweils eine konstante, vorher festgelegte Dauer T haben, wobei diese Vorrichtung Decodierungsmittel (9) umfaßt zum:

　a) Messen eines Wertes der charakteristischen elektrischen Größe des Signals während jeder Stufenperiode ($T_1$, $T_2$, $T_3$... $T_i$),
　b) und Identifizieren des durch jeden gemessenen Wert dargestellten Zustandes,

**dadurch gekennzeichnet, daß** die Decodierungsmittel (9) die Messungen der elektrischen Größe zu Zeitpunkten ($t_1$, $t_2$... $t_i$) ausführen, die von einem Ursprungszeitpunkt ($t_0$) durch ein ganzzahliges Vielfaches der Dauer T getrennt sind, wobei die Decodierungsmittel (9) zum Ermitteln des Ursprungszeitpunkts ($t_0$) vorgesehen sind, indem dicht aufeinanderfolgende Messungen der charakteristischen elektrischen Größe während einer vorher festgelegten sogenannten Synchronisierungsperiode in zueinander durch eine Dauer T/m getrennten Zeitpunkten ausgeführt werden, wobei m eine ganze Zahl von wenigstens 3 ist, wobei diese Decodierungsmittel auch zur Benutzung dieser dicht aufeinanderfolgenden Messungen ausgelegt sind, um die Stufenperioden der charakteristischen elektrischen Größe (U) festzulegen, und wobei die Decodierungsmittel (9) schließlich ausgelegt sind, um den Ursprungszeitpunkt ($t_0$) im wesentlichen bei der Hälfte einer dieser Stufenperioden festzusetzen.

**14.** Vorrichtung nach Anspruch 13, bei der die Decodierungsmittel (9) zum Identifizieren des für jeden gemessenen Wert dargestellten Zustandes vorgesehen sind, indem der gemessene Wert mit n-1 Schwellen $S_1$, $S_2$... $S_{n-1}$ verglichen wird, die n Bereiche von Werten begrenzen, die jeweils einem Zustand des elektrischen Signals entsprechen, wobei die Decodierungsmittel auch vorgesehen sind, um diese Schwellen vorher wenigstens abhängig von einem Minimalwert $U_1$ und von einem Maximalwert $U_n$ der während einer vorher festgelegten sogenannten Anpaßperiode gemessenen charakteristischen elektrischen Größe (U) festzusetzen.

**15.** Vorrichtung nach Anspruch 14, bei der die Decodierungsmittel vorgesehen sind, um während der Anpaßperiode Werte $U_1$, $U_2$... $U_n$ des charakteristischen elektrischen Werts (U) zu messen, die den n betreffenden Zuständen des Signals entsprechen, und um die verschiedenen Schwellen durch die folgende Formel zu berechnen:

$$S_k = \frac{U_k + U_{k+1}}{2},$$

wobei k eine ganze Zahl zwischen 1 und n-1 ist, und wobei die Vorrichtung außerdem einen Permanentspeicher enthält, in dem die verschiedenen während der Anpaßperiode gemessenen Werte $U_1$, $U_2$... $U_n$ gespeichert werden.

**16.** Empfängeranordnung (1), die eine Antenne (4) zum Empfangen eines frequenzmodulierten Funksignals, Mittel (7, 8) zum Erzeugen eines demodulierten elektrischen Signals (d), ausgehend von dem durch die Antenne (4) aufgenommenen frequenzmodulierten Signal, und eine Vorrichtung nach einem der Ansprüche 13 bis 15 enthält, um das demodulierte elektrische Signal (d) zu decodieren.

**Claims**

**1.** A method of decoding a multivalent electrical signal (d) capable of taking up a number $\underline{n}$ of states greater than 2, said signal having a characteristic electrical magnitude U which varies over time to take up successive values each representing one of the $\underline{n}$ states of the electrical signal (d), the characteristic electrical magnitude substantially retaining said successive values during pause periods ($T_1$, $T_2$, $T_3$, ..., $T_i$) each of predetermined constant duration T, the method including the following steps:

a) measuring a value of the characteristic electrical magnitude of the signal during each pause period ($T_1$, $T_2$, $T_3$, ..., $T_i$); and

b) identifying the state represented by each measured value;

the method being **characterized in that** the characteristic electrical magnitude U is measured at instants ($t_1$, $t_2$, ..., $t_i$) that are separated from a time origin ($t_0$) by an integer number of durations T, the time origin ($t_0$) being determined by performing close-together measurements of said characteristic electrical magnitude during a predetermined synchronization period at instants that are spaced apart from one another by a duration T/m, where $\underline{m}$ is an integer not less than 3, said close-together measurements being used to identify the pause periods in the characteristic electrical magnitude U, with the time origin ($t_0$) being set substantially in the middle of one of said pause periods.

**2.** A method according to claim 1, in which abovementioned step b) is performed by comparing the measured value with n-1 thresholds $S_1$, $S_2$, ..., $S_{n-1}$ which define $\underline{n}$ ranges of values each corresponding to one state of the electrical signal, said thresholds being previously fixed at least as a function of a minimum value $U_1$ and of a maximum value $U_n$ of the characteristic electrical magnitude U as measured during a predetermined adaptation period.

**3.** A method according to claim 2, in which the various thresholds $S_1$, $S_2$, ..., $S_{n-1}$ are determined not only as a function of the measured values $U_1$, $U_2$, ..., $U_n$, but also as a function of ideal values $U_10$, $U_20$, ..., $U_n0$ that the characteristic electrical magnitude U ought to take for the various states of the signal.

**4.** A method according to claim 3, in which the various thresholds are given by:

II) $$S_k = U_1 + (U_k0 - U_10) \frac{U_n - U_1}{U_n0 - U_10}$$

$$+ \tfrac{1}{2}(U_{k+1}0 - U_k0) \frac{U_n - U_1}{U_nO - U_10}$$

where $\underline{k}$ is an integer lying in the range 1 to n-1, $U_10$ being the smallest of the above-mentioned ideal values, $U_n0$ being the largest of the above-mentioned ideal values, and $U_k0$ and $U_{k+1}0$ being respectively the k-th and the (k+1)-th of said ideal values in increasing order.

**5.** A method according to claim 2, in which values $U_1$, $U_2$, ..., $U_n$ of the characteristic electrical magnitude U corresponding respectively to the $\underline{n}$ states of the signal are measured during the adaptation period, with the various thresholds then being given by:

$$S_k = \frac{U_k + U_{k+1}}{2}$$

where $k$ is an integer number lying in the range 1 to n-1, $U_k$ and $U_{k+1}$ being respectively the k-th and the (k+1)-th of said measured values in increasing order.

6. A method according to claim 2, in which the various thresholds are given by:

I) $\quad S_k = U_1 + (k - 0.5)\,\dfrac{U_n - U_1}{n-1}$

where $k$ is an integer lying in the range 1 to n-1.

7. A method according to any one of claims 2 to 6, in which the n-1 thresholds $S_1$, $S_2$, ..., $S_{n-1}$ are regularly updated during decoding of the signal (d), by determining at least the minimum value $U_1$ and the maximum value $U_n$ of the characteristic electrical magnitude during successive adaptation periods.

8. A method according to any one of claims 2 to 7, in which, while calculating the thresholds $S_1$, $S_2$, ..., $S_{n-1}$, the minimum value $U_1$ and the maximum value $U_n$ as determined during the adaptation period are compared respectively with first and second ranges of predetermined values, the minimum value being rejected if it does not lie within the first range of values and the maximum value being rejected if it does not lie within the second range of values.

9. A method according to any one of claims 2 to 8, in which the n-1 thresholds include a minimum threshold $S_1$ and a maximum threshold $S_{n-1}$, and in which, during step b), each measured value of the characteristic electrical magnitude of the signal is compared firstly with a value $S_1-\Delta$ and secondly with a value $S_{n-1}+\Delta$, $\Delta$ being a predetermined value, the measured value not being taken into account if it is less than $S_1-\Delta$ or greater than $S_{n-1}+\Delta$.

10. A method according to claim 9, in which the value $\Delta$ represent a constant fraction of the difference between the maximum threshold $S_{n-1}$ and the minimum threshold $S_1$.

11. A method according to any preceding claim, in which $m$ is an integer not less than 7.

12. A method according to any preceding claim, in which the electrical signal (d) is the result of demodulating a modulated radio signal.

13. Apparatus for decoding a multivalent electrical signal (d) capable of taking up a number $n$ of states greater than 2, said signal having a characteristic electrical magnitude U which varies over time to take successive values each representative of one of the n states of the electrical signal (d), the characteristic electrical magnitude substantially conserving said successive values during pause periods ($T_1$, $T_2$, $T_3$, ..., $T_i$) each having a predetermined constant duration T, said apparatus including decoder means (9) to:

> a) measure a value of the characteristic electrical magnitude of the signal during each pause period ($T_1$, $T_2$, $T_3$, ..., $T_i$); and
> b) identify the state represented by each measured value;

the apparatus being **characterized in that** the decoder means (9) measure the electrical magnitude at instants ($t_1$, $t_2$, ..., $t_i$) that are separated from a time origin ($t_0$) by an integer number of durations T, said decoder means (9) being designed to determine the time origin ($t_0$) by performing close-together measurements of said characteristic electrical magnitude during a predetermined synchronization period at instants which are spaced apart from one another by a duration T/m, where $m$ is an integer not less than 3, the decoder means also being designed to use said close-together measurements to identify the pause periods of the characteristic electrical magnitude U, and the decoder means (9) finally being designed to set the time origin ($t_0$) substantially in the middle of one of said pause periods.

14. Apparatus according to claim 13, in which the decoder means (9) are designed to identify the state represented by each measured value by comparing said measured value with n-1 thresholds $S_1$, $S_2$, ..., $S_{n-1}$ defining $n$ ranges of values each corresponding to one state of the electrical signal, the decoder means also being designed initially to set said thresholds at least as a function of a minimum value $U_1$ and of a maximum value $U_n$ of the characteristic electrical magnitude U as measured during a predetermined adaptation period.

15. Apparatus according to claim 14, in which the decoder means are designed during said adaptation period to measure the values $U_1$, $U_2$, ..., $U_n$ of the characteristic electrical magnitude corresponding respectively to the $n$ states of the signal, and to calculate the various thresholds using the following formula:

$$S_k = \frac{U_k + U_{k+1}}{2}$$

where $\underline{k}$ is an integer lying in the range 1 to n-1, and the apparatus further includes a non-volatile memory in which said various values $U_1$, $U_2$, ..., $U_n$ measured during the adaptation period are stored.

16. A receiver assembly (1) including an antenna (4) for receiving a frequency modulated radio signal, means (7, 8) for generating a demodulated electrical signal (d) from the frequency modulated radio signal picked up by the antenna (4), and apparatus according to any one of claims 13 to 15, for decoding the demodulated electrical signal (d).

FIG.1

FIG.2

FIG.3